# FASCICULE DE BREVET EUROPEEN

(11) **EP 0 762 811 B1**
(45) Date de publication et mention de la délivrance du brevet: **27.01.1999**
(21) Numéro de dépôt: 96401738.8
(22) Date de dépôt: 06.08.1996
(51) Int. Cl.: H05K 3/28, H01L 23/29

(54) **Circuit électronique à microcomposants encapsulé et procédé de démontage d'un tel circuit**
Verkapselte elektronische Schaltung mit Mikrobauteilen und Verfahren zu deren Demontage
Encapsulated electronic circuit having micro components and process for dismounting such a circuit

(30) Priorité: 09.08.1995 FR 9509673
(43) Date de publication de la demande: 12.03.1997
(73) Titulaire: MATRA DEFENSE, 75116 Paris (FR)
(72) Inventeur: Lecaplain, Jacques, 78140 Velizy-Villacoublay (FR)
(74) Mandataire: Fort, Jacques

(56) Documents cités:
- EP-A- 0 182 371
- EP-A- 0 508 286
- WO-A-92/03902
- FR-A- 2 685 159
- US-A- 4 946 549
- US-A- 5 439 849

## Description

L'invention concerne les circuits électroniques comprenant des micro-composants tels que des puces de circuits intégrés et/ou des pavés de composants, actifs ou non, portés par une carte de circuit imprimé. Elle trouve une application particulièrement importante dans le domaine des circuits électroniques dont les micro-composants sont fixés à la carte par une technologie dite de montage en surface.

Les micro-composants d'un tel circuit doivent être protégés contre les agressions. Pour cela, on utilise couramment diverses solutions. En particulier, on a proposé d'encapsuler les micro-composants par une couche solide, continue, imperméable à l'air, de quelques dizaines de µm d'épaisseur, de matériau organique déposé sous vide. Cette technique a de nombreux avantages. La couche immobilise les particules métalliques microscopiques qui pourraient provoquer des court-circuits. En cas de dépôt sous vide, le risque d'inclusion de bulles est évité et il ne subsiste pas de cavités closes qui seraient sensibles aux variations de pression, particulièrement à craindre dans le cas des circuits destinés à être montés sur les engins spatiaux.

Parmi les matériaux utilisés pour constituer la couche, on peut notamment citer le polyparaxylylène, obtenu à partir de précurseurs disponibles dans le commerce. De tels précurseurs sont constitués par des diomères sublimables sous vide primaire. La vapeur de dimère est pyrolisée vers 680°C pour fournir le p-xylylène monomère réactif gazeux, qui peut se condenser sur les surfaces à revêtir sous forme d'un polymère. Ces précurseurs sont notamment vendus sous la marque "Parylène" par la société Union Carbide.

De telles couches sont, par exemple, connus de FR-A-2 685 159, qui, de plus, envisage le dépôt d'une couche composite en deux opérations successives, la couche interne assurant l'herméticité alors que la couche externe constitue une barrière évitant l'action de l'oxygène sur la couche interne; (Parylène C et Parylène D par exemple).

Souvent, on utilise une épaisseur de polyparaxylylène comprise entre 10 et 15 µm.

On a également proposé (WO-A-9 203 902) de constituer une couche composite ayant une couche inférieure en parylène ou vernis et une couche supérieure en matériau mineral, tel que Si₃N₄.

On réalise à l'heure actuelle des circuits électroniques à micro-composants très complexes, portant un grand nombre de micro-composants. Leur coût et celui des micro-composants est très élevé. Il se pose alors le problème du remplacement d'un micro-composant dont le fonctionnement devient défectueux. Lorsque le circuit électronique est enrobé, il doit être décapé, puis le circuit défectueux doit être retiré sans endommager les pistes de la carte.

Parmi les procédés de décapage connus, on utilise notamment l'attaque de l'enrobage par un plasma obtenu par excitation à radiofréquence d'un mélange d'oxygène et de produit fluoro-carboné, tel que CF4. Appliqué à un enrobage de polyparaxylylène, ce procédé d'attaque a donné des résultats peu satisfaisants. Il est difficile de doser l'attaque pour éliminer le polyparaxylylène sans attaquer localement le substrat. Le réglage de la puissance à radiofréquence est très délicat, car une puissance insuffisance ne permet pas le décapage et une puissance trop élevée provoque une réticulation superficielle du polyparaxylylène qui empêche la poursuite de l'attaque. Enfin, ce processus ne permet pas d'éliminer le polyparaxylylène qui a migré sous les composants montés en surface lors de l'enrobage et ces composants restent collés au substrat.

L'attaque par des solvants sélectifs, tel que celui connu sous la référence "Dynasolve 150", n'a pas non plus donné des résultats satisfaisants : pour éliminer le polyparaxylylène, il faut des durées d'attaque telles que le solvant migre dans les composants, et en particulier les résistances, en les endommageant. Le démontage des micro-composants montés à plat reste difficile, du fait des infiltrations de polyparaxylylène.

La présente invention vise notamment à fournir un circuit électronique à micro-composants encapsulé dont l'enrobage présente toutes les qualités obtenues à l'aide d'une couche de polyparaxylylène (ou d'un autre polymère organique isotrope de propriétés similaires), tout en autorisant un décapage satisfaisant, permettant ensuite de décoller un ou plusieurs composants sans endommager le composant ou le circuit.

Dans ce but, l'invention propose notamment un circuit électronique à micro-composants encapsulé suivant la revendication 1.

Le vernis peut notamment être l'un de ceux couramment utilisés en câblage tel que les vernis polyuréthane ou, moins fréquemment, les vernis époxy.

Le polymère organique sera en règle générale un polyparaxylylène, bien que l'on puisse également utiliser des dérivés de chlorure de vinyle et des copolymères de vinylène, qui sont cependant moins satisfaisants.

Le polyparaxylylène est obtenu à partir d'un produit qu'on vaporise sous vide primaire sous forme de monomère et qui se condense sur les surfaces à revêtir sous forme d'un polymère. Le précurseur utilisé pour constituer la couche de paraxylilène sera choisi en fonction des propriétés à favoriser : si par exemple on veut constituer une couche ayant une étanchéité absolue, on pourra utiliser un précurseur du Parylène C. Si on cherche à constituer une barrière à l'oxygène à température élevée, on pourra utiliser un autre précurseur tel que le Parylène D. Il est également possible de composer une couche composite, la partie interne étant étanche et la partie externe assurant une protection contre l'agression et/ou ayant un coefficient diélectrique élevé.

Dans la pratique, la couche de polyparaxylylène aura une épaisseur comprise entre 10 et 15 µm. La couche de vernis pourra être mince, de 15 à 25 um, et déposée par projection au pistolet ou revêtement au pinceau.

L'invention propose également un procédé de démontage d'un circuit électronique à micro-composants du genre décrit ci-dessus, suivant la revendication 4. Une teneur en volume de CF4 inférieure à 10 %, en général d'environ 6 %, et une durée d'attaque d'une heure trente se sont révélées suffisantes dans la plupart des cas pour éliminer une épaisseur de 10 à 15 µm de polyparaxylylène. Pour éviter l'attaque des zones du circuit non vernies et non revêtues, elles peuvent être protégées par un ruban plastique adhésif résistant à haute température.

Un micro-composant peut ensuite être enlevé sur une machine qui exerce une traction en même temps qu'elle dirige sur le composant un jet de gaz chaud de ramollissement du vernis et de fusion des soudures.

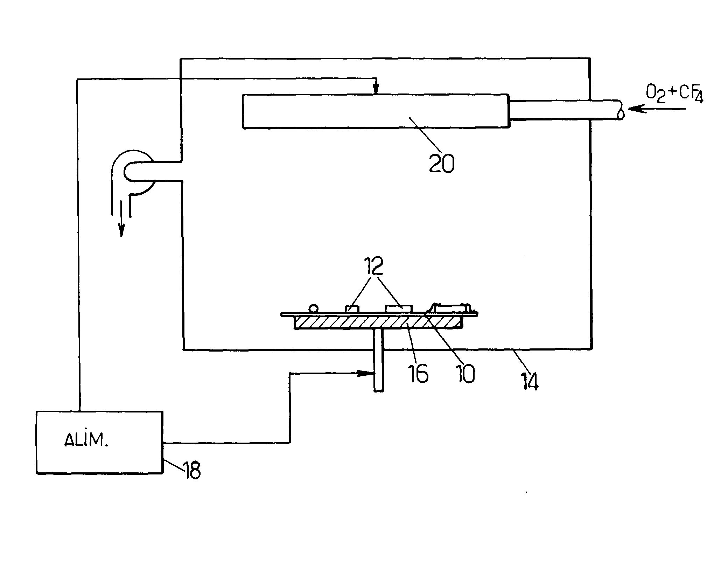

D'autres caractéristiques encore de l'invention apparaîtront à la lecture de la description qui suit d'un mode particulier d'exécution, donné à titre d'exemple non limitatif. La description se réfère à la figure unique qui l'accompagne et montre schématiquement un appareil dans lequel peut être mis en oeuvre le procédé de décapage.

Un circuit qui pourra être constitué suivant l'invention, montré sur la figure, comporte une carte à circuit imprimé 10 sur laquelle sont fixés des micro-composants discrets 12 de forme et de nature quelconques. Les micro-composants 12 sont câblés par des procédés qui peuvent être l'un quelconque de ceux couramment utilisés à l'heure actuelle (fil souple, brasure, et surtout montage en surface). Ils peuvent être maintenus mécaniquement sur la carte par une goutte de colle dont la résistance mécanique est faible.

Des raisons de coût conduisent de plus en plus à utiliser des composants plastiques plutôt que des composants céramiques. Ces composants plastiques doivent être protégés contre l'humidité. Conformément à l'invention, ce résultat est obtenu en revêtant au moins la face de la carte équipée de composants.

Le revêtement a une constitution composite. Il comprend une couche interne ou intérieure de vernis classique, en général polyuréthane, déposée habituellement par projection ou au pinceau. Ce mode de revêtement ne permet pas d'obtenir une épaisseur extrêmement régulière. Mais cela est sans inconvénient du fait que l'épaisseur moyenne sera toujours d'au moins 15 µm et le vernis sera protégé par une seconde couche. Le vernis permet d'immobiliser les composants et renforce la tenue mécanique des fils d'interconnexion éventuels. Il est de nature telle qu'il puisse être ramolli par un courant de gaz à une température qui permet de fondre également les soudures.

Une fois le vernis durci, le revêtement est complété par dépôt d'une couche de 10 à 15 µm de paraxylylène. Les précurseurs habituellement utilisés pour constituer de telles couches permettent d'obtenir une épaisseur très régulière, y compris sur les parties anguleuses. La présence du vernis empêche la formation de paraxylylène sous les composants, ce qui facilite un démontage éventuel ultérieur.

La couche de polyparaxylylène est constituée dans une enceinte mise sous vide primaire. Le précurseur, constitué par un dimère stable cristallin, est sublimé sous vide à une température d'environ 250°C. La vapeur est pyrolisée vers 680°C pour fournir un monomère qui se dépose et se polymérise sur la carte et les composants. Le polyparaxylylène ainsi constitué forme une couche isotrope, transparente, régulière. Certains des précurseurs de polyparaxylylène, et notamment celui vendu sous la référence "Parylène C", fournissent une couche présentant un imperméabilité élevée à l'humidité et au gaz. Dans certains cas, la couche de polyparaxylylène peut elle-même être composite et comporter deux natures de polyparaxylylène différentes, à condition qu'elles soient l'une et l'autre attaquable par un plasma froid.

Lorsqu'il est nécessaire de remplacer un composant, les parties du circuit à protéger peuvent être tout d'abord recouvertes d'un ruban adhésif transparent. Puis la carte est placée dans une enceinte 14 de réaction, sur un support 16 polarisable par une alimentation 18. L'enceinte est prévue pour recevoir un courant d'un mélange d'oxygène et le composé fluoro-carboné. Un tel composé fluoro-carboné est préférable à des composés chlorés, du fait de l'agressivité et de la toxicité de ces derniers. Le gaz est reçu dans une enceinte 20 de formation de plasma soumis à un champ électro-magnétique à radiofréquence. Les ions du plasma sont accélérés de façon directive vers la carte de circuit imprimé par un champ électrique.

La durée d'attaque peut être déterminée par des essais préalables. Il est également possible de surveiller l'attaque en vérifiant de façon optique l'épaisseur résiduelle de la couche transparente de polyparaxylylène. Il est également possible de rendre la couche de polyparaxylylène fluorescente sous ultraviolets, de façon à surveiller optiquement la disparition de la couche en dirigeant un faisceau UV vers la carte. Mais, du fait de la présence d'une couche relativement épaisse de vernis, une prolongation de la durée d'attaque au-delà de ce qui est nécessaire pour décaper la couche de polyparaxylylène ne présente pas d'inconvénient grave.

Le décapage doit être effectué à une température inférieure à 90°C, pour ne pas risquer de provoquer une réticulation superficielle de la couche qui la rendrait résistante à l'attaque par le plasma.

Le décapage par plasma peut être complété par un traitement chimique à l'aide d'un solvant. Toutefois, l'attaque complémentaire exige des précautions, du fait que les solvants applicables au polyparaxylylène sont très agressifs.

Une fois la couche de polyparaxylyne éliminée, un composant peut être retiré en utilisant un appareil de montage de nature classique, comprenant une ventouse d'arrachement du composant et une buse destinée à souffler un gaz chaud (azote ou même air) destiné à ramollir le vernis et à fondre la soudure. Dans le cas fréquent où les composants sont fixés par une soudure étain-plomb dont le point de fusion est d'environ 180°C, un flux d'air à une température d'environ 200°C donne en règle générale des résultats satisfaisants.

Une fois le composant retiré, il peut être remplacé par un autre qui est ressoudé. Dans le cas où on ne prévoit plus de réparation, le revêtement peut être directement constitué en polyparaxylylène. Dans le cas contraire, il est encore possible de constituer un revêtement composite, comprenant une couche inférieure de vernis et une couche supérieure de polyparaxylylène.

## Revendications

1. Circuit électronique encapsulé comprenant des micro-composants portés par une carte de circuit imprimé,
la carte et les micro-composants étant recouverts d'un revêtement composite, caractérisé en ce que le revêtement est formé d'une couche de vernis, d'épaisseur comprise entre 15 et 25 µm, et d'une couche supérieure étanche mince d'un matériau organique polymère non poreux, d'épaisseur supérieure à 10 µm.

2. Circuit selon la revendication 1, caractérisé en ce que le matériau organique est constitué par du polyparaxylylène.

3. Circuit selon la revendication 1 ou 2, caractérisé en ce ce que la couche de matériau organique a une épaisseur comprise entre 10 et 15 µm.

4. Procédé de démontage d'un circuit électronique à micro composant suivant la revendication 1, 2 ou 3, suivant lequel on attaque la couche étanche mince par un plasma obtenu par excitation radiofréquence d'un courant de mélange O₂ + CF4, puis on enlève un ou ces micro-composants en exerçant sur le micro-composant une traction en même temps qu'on dirige sur le micro-composant un jet de gaz chaud de ramollissement du vernis et de fusion des soudures du micro-composant.

5. Procédé selon la revendication 4, caractérisé en ce que l'attaque par un plasma s'effectue à une température inférieure à 90°C.

6. Procédé selon la revendication 4 ou 5, caractérisé en ce que la teneur en volume de CF4 est d'environ 6 %.

## Patentansprüche

1. Verkapselte elektronische Schaltung mit Mikrobestandteilen, die von einer Platine mit aufgedruckter Schaltung getragen sind, wobei die Platine und die Mikrobestandteile mit einem Kompositüberzug bedeckt sind, dadurch gekennzeichnet, daß der Überzug aus einer Lackschicht von einer Dicke zwischen 15 und 25 µm und einer dünnen oberen dichtenden Schicht aus einem organischen nicht-porösen Polymermaterial einer Dicke von mehr als 10 µm gebildet ist.

2. Schaltung nach Anspruch 1, dadurch gekennzeichnet, daß das organische Material gebildet ist aus Polyparaxylylen.

3. Schaltung nach Anspruch 1 oder 2, dadurch gekennzeichnet, daß die Schicht aus organischem Material eine Dicke aufweist zwischen 10 und 15 µm.

4. Verfahren zur Demontage einer elektronischen Schaltung mit Mikrobestandteilen nach Anspruch 1, 2 oder 3, bei welchem die dünne dichtende Schicht mit einem Plasma bearbeitet wird, erhalten durch Radiofrequenzerregung eines Mischstromes O₂ + CF4, wonach man einen oder mehrere Mikrobestandteile entfernt, indem man an dem Mikrobestandteil einen Zug bewirkt, gleichzeitig zu dem Richten eines heißen Gasstrahles auf den Mikrobestandteil, welcher den Lack erweicht und die Verlötungen des Mikrobestandteiles schmilzt.

5. Verfahren nach Anspruch 4, dadurch gekennzeichnet, daß die Bearbeitung mittels Plasma bei einer Temperatur von weniger als 90°C erfolgt.

6. Verfahren nach Anspruch 4 oder 5, dadurch gekennzeichnet, daß der Volumengehalt an CF4 etwa 6% ausmacht.

## Claims

1. Encapsulated electronic circuit containing micro components supported by a printed circuit board, the board and the micro components being covered by a composite coating, characterised in that the coating is formed by a layer of lacquer having a thickness of between 15 and 25 µm, and an upper thin sealing layer of a non-porous, organic polymer material, having a thickness exceeding 10 µm.

2. Circuit according to Claim 1, characterised in that the organic material is composed of polyparaxylylene.

3. Circuit according to Claim 1 or 2, characterised in that the layer of organic material has a thickness of between 10 and 15 µm.

4. Process for dismantling an electronic circuit containing micro components according to Claim 1, 2 or 3, by which the thin sealing layer is attacked by a plasma obtained by radio-frequency excitation of a stream of mixed gases comprising O₂ - CF₄, then one or more micro components are removed by applying a tractive force at the same time as a jet of hot gas is directed onto the micro component to soften the lacquer and to fuse the solder joints of the micro component.

5. Process according to Claim 4, characterised in that the plasma attack is effected at a temperature that is below 90°C.

6. Process according to Claim 4 or 5, characterised in that the concentration of CF₄ by volume is approximately 6 %.
